(19) Europäisches Patentamt
European Patent Office
Office européen des brevets

(11) Publication number: **0 560 347 A1**

# (12) EUROPEAN PATENT APPLICATION

(21) Application number: **93103896.2**

(22) Date of filing: **10.03.93**

(51) Int. Cl.$^5$: **B41N 3/03**, B41M 1/08, G03F 7/075

(30) Priority: **12.03.92 JP 53172/92**

(43) Date of publication of application: **15.09.93 Bulletin 93/37**

(84) Designated Contracting States: **DE GB**

(71) Applicant: **Fuji Photo Film Co., Ltd.**
**210 Nakanuma Minamiashigara-shi**
**Kanagawa-ken(JP)**

(72) Inventor: **Okuno, Kei, c/o FUJI PHOTO FILM CO., LTD.**
**4000, Kawashiri, Yoshida-cho**
**Haibara-gun, Shizuoka-ken(JP)**
Inventor: **Sakaki, Hirokazu, c/o FUJI PHOTO FILM CO., LTD.**
**4000, Kawashiri, Yoshida-cho**
**Haibara-gun, Shizuoka-ken(JP)**

(74) Representative: **Patentanwälte Grünecker, Kinkeldey, Stockmair & Partner**
**Maximilianstrasse 58**
**D-80538 München (DE)**

## (54) Method for preparing dry lithographic plates.

(57) A method for preparing a dry PS plate which comprises an aluminum plate as a substrate, wherein the method comprises the steps of degreasing at least one side of she aluminum substrate to which a light-sensitive layer is applied with an aqueous solution of an acid and then applying a light-sensitive layer and an ink-repellent layer to the degreased substrate. The dry PS plate comprising an aluminum plate as a substrate prepared by the method permits the substantial improvement of coating properties of films applied onto the aluminum plate, developability and half-tone dot reproduction as well as storage stability of these properties.

EP 0 560 347 A1

## BACKGROUND OF THE INVENTION

The present invention relates to a presensitized plate for use in making a lithographic printing plate requiring no dampening water (hereinafter referred to as "dry PS plate") comprising an aluminum plate as a substrate and more specifically to a method for preparing a dry PS plate in which an aluminum substrate ensures excellent coating properties of films to be applied to the substrate and which is excellent in developability and half-tone dot reproduction as well as storage stability of these properties.

There have been proposed various kinds of lithographic printing plate requiring no dampening water which allows lithographic printing without using any dampening water (hereinafter referred to as "dry lithographic plate"). Among these, those comprising a substrate provided thereon with, in order, a light-sensitive layer and an ink-repellent layer have particularly excellent properties. Examples thereof include those comprising silicone rubbers as the ink-repellent layers as disclosed in Japanese Patent Publication for Opposition Purpose (hereinafter referred to as "J.P. KOKOKU") Nos. Sho 54-26923(=U.S.Patent No. 3,894,873), Sho 55-22781 (=British Patent No. 1,419,643) and Sho 56-23150 and Japanese Unexamined Patent Publication (hereinafter referred to as "J.P. KOKAI") No. Hei 2-236550 and those comprising fluorine atom-containing resins as the ink-repellent layers as disclosed in J.P. KOKAI Nos. Sho 58-215411 and Hei 2-103047.

Aluminum plates have widely been used as substrates for these dry PS plates, but fats and oils such as rolling oils and lubricating oils, and contaminants are in general adhered to these aluminum plates through the rolling process and cannot easily be removed. If a coating film is applied onto the aluminum plate thus covered with rolling oils or the like, any uniform coating film cannot be formed on the plate since the surface thereof repels the coating solution.

For this reason, a chemical pretreatment called degreasing has generally been carried out prior to the formation of a coating film on an aluminum plate as a substrate. The degreasing of the aluminum plate for lithographic printing plates is generally performed by washing it with an aqueous solution of sodium hydroxide as disclosed in J.P. KOKAI No. Sho 55-113595, which more specifically comprises dipping the aluminum plate in an aqueous solution of sodium hydroxide having a concentration of 5 to 10% at a temperature ranging from 40 to 60 °C for 30 to 60 seconds, then washing with water and neutralizing the plate. When an aluminum plate is degreased with an aqueous solution of sodium hydroxide, and water-washing and neutralization thereof are insufficient, however, aluminum hydroxide formed through the reaction with aluminum on the surface thereof and hydroxides of impurities included in the aluminum plate (such as iron hydroxide and copper hydroxide) remain on the surface and, therefore, the developability of a dry PS plate prepared by applying a light-sensitive layer and a silicone rubber layer onto the aluminum plate is greatly impaired during storage.

As degreasing methods which are not accompanied by any formation of aluminum hydroxide and hydroxides of impurities included in the aluminum plate (such as iron hydroxide and copper hydroxide), there have been known methods comprising washing an aluminum plate with an organic solvent or an aqueous solution of a surfactant, but these methods are still insufficient since they suffer from problems. For instance, the use of organic solvents is undesirable from the viewpoint of safety and hygiene and an aqueous solution of a surfactant does not ensure sufficient degreasing.

## SUMMARY OF THE INVENTION

Accordingly, an object of the present invention is to solve the foregoing problems associated with the conventional methods and more specifically to provide a method for preparing a dry PS plate in which an aluminum plate can ensure excellent coating properties of films to be subsequently applied onto the aluminum plate and which is excellent in developability and half-tone dot reproduction as well as storage stability of these properties.

The inventors of this invention have conducted intensive studies to eliminate the foregoing problems, have found that the degreasing of an aluminum substrate is very important to accomplish the foregoing object and thus have completed the present invention.

The present invention thus relates to a method for preparing a dry PS plate which comprises an aluminum plate as a substrate and the method comprises the steps of degreasing at least one side of the aluminum substrate to which a light-sensitive layer is subsequently applied with an aqueous solution of an acid and then applying a light-sensitive layer and an ink-repellent layer to the degreased substrate.

DESCRIPTION OF THE PREFERRED EMBODIMENTS

The present invention will hereinafter be described in more detail.

Substrate

An aluminum plate used as a substrate is a plate-like material of pure aluminum or an aluminum alloy mainly comprising aluminum and trace amounts of foreign atoms. Examples of these foreign atoms include silicon, iron, manganese, copper, magnesium, chromium, zinc, bismuth, nickel and titanium. The content of these foreign atoms in the aluminum alloy is not more than 10% by weight. Pure aluminum can be preferably used as a material for substrates employed in the present invention, but the poduction of completely pure aluminum is difficult from the viewpoint of refining techniques and thus preferred are those having a low content of foreign atoms. The aluminum alloys having the contents of foreign atoms defined above can be used in the present invention as materials for preparing substrates. As has been discussed above, the aluminum plates used in the present invention need not have specific compositions and accordingly those conventionally known and currently used can be employed in the present invention. Thus, any know and/or used aluminum materials such as JIS A1050, JIS A1100, JIS A1200, JIS A3103, JIS A3003 and JIS A3005 can be suitably used in the present invention, but the invention is not limited to specific materials. The thickness of the aluminum plate used in the invention ranges from about 0.1 to 0.5 mm.

Degreasing Treatment

An aluminum plate of this type is first treated with an aqueous solution of an acid to remove the rolling oils from the surface thereof. Acids used in this step may be any known acid used for washing metals and examples thereof include inorganic acids such as hydrochloric acid, sulfuric acid, nitric acid, hydrofluoric acid, phosphoric acid, sulfamic acid and chromic acid; and organic acids such as citric acid, gluconic acid, oxalic acid, tartaric acid, formic acid, hydroxyacetic acid, EDTA (ethylenediaminetetraacetic acid) and derivatives thereof and ammonium thioglycollic acid. These acids may also be used in combination. The treatment with acid can be performed by showering an acid aqueous solution on an aluminum plate, dipping in or coating with an acid aqueous solution. At least one of sides of the aluminum plate to which a light-sensitive layer is subsequently applied is degreased with an acid, but more preferably the back face thereof is likewise degreased. Among the foregoing acids, mineral acids are preferred because of, for instance, cost, stability of the washing solution with time, washing efficiency and safety, with sulfuric acid and phosphoric acid being more preferred. Preferred conditions for this treatment cannot absolutely be specified, but in general the concentration of the acid aqueous solution ranges from 15 to 50% by weight, preferably 20 to 50% by weight; the temperature ranges from 30 to 100 °C, preferably 40 to 80 °C; and the treating time ranges from 1 second to 10 minutes, preferably 1 to 100 seconds. If the concentration of the solution is less than the foregoing lower limit, the degreasing of the aluminum plate is insufficient and accordingly satisfactory coating properties cannot be ensured, while the use of the concentration exceeding the upper limit is not preferred from the viewpoint of the safety during handling the acid solution. Moreover, the aluminum plate is preferably washed with water for an appropriate time period after the acid-treatment.

After the degreasing treatment, coating films such as a light-sensitive layer may directly be applied thereto, but the plate may be subjected to surface-treatments such as graining, anodization and/or treatments with aqueous solutions of silicates such as sodium silicate and potassium silicate (also referred to as "silicate treatments"), with the silicate-treatment being preferred. These surface-treatments are preferably carried out after the step of the foregoing degreasing with an acid aqueous solution. The substrate can likewise be optionally treated with a silane-coupling agent prior to coating the film to improve adhesion between the film subsequently applied and the aluminum plate.

Primer Layer

For preventing halation from the surface of the aluminum plate, the aluminum plate thus degreased can preferably be coated with a primer layer before providing a light-sensitive layer on the aluminum plate.

Various kinds of primer layers may be used for the improvement of adhesion between the substrate and a light-sensitive resin layer, for inhibiting halation, for dyeing images and for improving printing properties. Examples thereof include those obtained by hardening various light-sensitive polymers through exposure to light prior to the application of a light-sensitive resin layer as disclosed in J.P. KOKAI No. Sho 60-229031; those obtained by hardening epoxy resins through heating as disclosed in J.P. KOKAI No. Sho 62-50760;

those obtained by hardening gelatin as disclosed in U.S. Pat. No. 4,861,698; those obtained from urethane resins and silane-coupling agents as disclosed in U.S. Pat. No. 5,061,598; those obtained from urethane resind and diazo resins as disclosed in J.P. KOKAI No. Hei 3-273248 which corresponds to U.S. Patent Application, Serial No. 643,893 filed on Jan. 22, 1991; and those obtained by hardening coated films comprising hydroxyl group-containing polymers and diazo resins through irradiation with UV rays as disclosed in Published European Patent EP 0394924A. In addition, hardened films of gelatin or casein are also effective. Among these, particularly preferred include primer layers comprising urethane resins and diazo resins or those obtained by hardening these primer layer through irradiation with UV rays. Further the primer layers may comprise, for the improvement of flexibility thereof, polymers having glass transition temperatures of not more than room temperature such as polyurethane, polyamide, styrene/butadiene rubber, carboxy-modified styrene/butadiene rubber, acrylonitrile/butadiene rubber, carboxy-modified acrylonitrile/butadiene rubber, polyisoprene, acrylate rubber, polyethylene, chlorinated polyethylene and chlorinated polypropylene. The amount thereof is not restricted to a specific range so far as they can form film layers and these additives per se may form a primer layer. These primer layers may comprise additives such as dyes, pH indicators, printing out agents, photopolymerization initiators, adhesive aids (such as polymerizable monomers, diazo resins, silane-coupling agents, titanate-coupling agents and aluminum-coupling agents), pigments and silica powder. In general, the amount of the primer layer to be applied suitably ranges from 0.1 to 20 $g/m^2$, preferably 1 to 10 $g/m^2$ (weighed after drying).

## Light-sensitive Layer

Light-sensitive layers used in the invention may be, for instance, photopolymerizable light-sensitive layers, photocrosslinkable light-sensitive layers and light-sensitive layers comprising diazo resins and binder resins, with photopolymerizable light-sensitive layers being preferred.

The photopolymerizable light-sensitive layer comprises at least (1) a monomer, oligomer or macromonomer having at least one photopolymerizable ethylenically unsaturated group; (2) a polymeric compound having a film-forming ability; and (3) a photopolymerization initiator.

### Component (1): Monomer, Oligomer or Macromonomer Having at least one Photopolymerizable Ethylenically Unsaturated Group

Examples of the foregoing monomers, oligomers or macromonomers usable in the present invention are as follows:

(A) Acrylates or methacrylates of alcohols (such as ethanol, propanol, hexanol, 2-ethylhexanol, cyclohexanol, glycerin, hexanediol, trimethylolpropane, pentaerythritol, sorbitol, triethylene glycol, polyethylene glycol and polypropylene glycol);

(B) Reaction products of amines (such as ethylamine, butylamine, benzylamine, ethylenediamine, hexamethylenediamine, diethylenetriamine, xylylenediamine, ethanolamine and aniline) with glycidyl acrylate, glycidyl methacrylate or allyl glycidyl;

(C) Reaction products of carboxylic acids (such as acetic acid, propionic acid, benzoic acid, acrylic acid, methacrylic acid, succinic acid, maleic acid, phthalic acid, tartaric acid and citric acid) with glycidyl acrylate, glycidyl methacrylate or allyl glycidyl; and

(D) amide derivatives such as acrylamide, N-methylolacrylamide, t-butylacrylamide, methylenebisacrylamide and diacetoneacrylamide).

Moreover, examples of the foregoing monomers, oligomers or macromonomers further include urethane acrylates as disclosed in J.P. KOKOKU Nos. Sho 48-41708 and Sho 50-6034 and J.P. KOKAI No. Sho 51-37193; polyester acrylates as disclosed in J.P. KOKAI No. Sho 48-64183, J.P. KOKOKU Nos. Sho 49-43191 and Sho 52-30490; multifunctional acrylates and methacrylates such as epoxyacrylates obtained by reacting epoxy resins with (meth) acrylic acid; and N-methylolacrylamide derivatives as disclosed in U.S. Patent No. 4,540,649. It is also possible to use those disclosed in Bulletin of the Adhesive Society of Japan, 1984, Vol. 20, No. 7, pp. 300-308 as photohardenable monomers and oligomers; and macromonomers as disclosed in, for instance, P. Dreyfuss & R.P. Quirk, Encycl. Polym. Sci. Eng., 1987, 7, p. 551, KAGAKU KOGYO (Chemical Industries), 1987, 38, P. 56 and KOBUNSHI KAKO (Polymer Processing), 1986, 35, p. 262. However, the present invention is not restricted to these specific examples and the multifunctional monomers may comprise combinations of acryl, methacryl, allyl and/or vinyl groups as the unsaturated groups. Moreover, these compounds may be used alone or in combination. The amount of these compounds ranges from 5 to 80% by weight and preferably 30 to 70% by weight on the basis of the total weight of the solid contents of the photopolymerizable light-sensitive layer.

Component (2): Polymeric Compound Having Film-forming Ability

Examples of polymeric compounds having film-forming ability used in the invention include polyester resins, vinyl chloride/vinyl acetate copolymers, acryl resins, vinyl chloride resins, polyamide resins, epoxy resins, (meth)acrylate copolymers, (meth)acrylamide copolymers, polyurethane resins, vinyl acetate copolymers, polystyrene, phenoxy resins, polyvinyl chloride, acidic cellulose derivatives, alcohol-soluble polyamides, (meth)acrylic acid copolymers, maleic acid copolymers, polyvinyl alcohol, water-soluble polyamides, water-soluble urethanes, water-soluble celluloses and polyvinyl pyrrolidone.

In addition, examples of polymeric compounds having film-forming ability further include polymeric compounds having, on the side chains, photopolymerizable or photocrosslinkable ethylenically unsaturated double bonds. However, the present invention is not restricted to the foregoing polymers.

Component (3): Photopolymerization Initiator

Typical examples of photopolymerization initiators usable in the present invention are as follows:

a) Benzophenone derivatives such as benzophenone, Michler's ketones, xanthone, anthrone, thioxanthone, acridone, 2-chloroacridone, 2-chloro-N-n-butylacridone, 2, 4-diethylthioxanthone and fluorenone;

b) Benzoin derivatives such as benzoin, benzoin methyl ether and benzoin ethyl ether;

c) Quinones such as p-benzoquinone, β-naphthoquinone and β -methylanthraquinone;

d) Sulfur atom-containing compounds such as dibenzyldisulfide and di-n-butyldisulfide;

e) Azo and diazo compounds such as 2-azobisisobutyronitrile, 1-azo-bis-1-cyclohexanecarbonitrile, p-diazobenzylethyl aniline and Congo Red;

f) Halogen atom-containing compounds such as carbon tetrabromide, silver bromide, α-chloromethylnaphthalene and trihalomethyl-s-triazine compounds; and

g) Peroxides such as benzoyl peroxide.

These photopolymerization initiators may be used alone or in combination. The amount of these photopolymerization initiators ranges from 0.1 to 25% by weight and preferably 3 to 20% by weight on the basis of the total weight of the composition for preparing the light-sensitive layer.

Miscellaneous Components

Preferably, the composition for light-sensitive layers further comprises, in addition to the foregoing components, a heat-polymerization inhibitor whose useful examples include hydroquinone, p-methoxyphenol, di-t-butyl-p-cresol, pyrogallol, t-butylcatechol, 4,4'-thiobis(3-methyl-6-t-butylphenol), 2,2'-methylenebis(4-methyl-6-t-butylphenol) and 2-mercaptobenzimidazole. The light-sensitive layer may optionally comprise a dye or pigment for dyeing the light-sensitive layer and a pH or leuco dye as an agent or composition for obtaining a visible image immediately after imagewise exposure. It may further comprise a small amount of a silicone compound such as polydimethylsiloxane, methylstyrene-modified polydimethylsiloxane, olefin-modified polydimethylsiloxane, polyether-modified polydimethylsiloxane, silane-coupling agent, silicone diacrylate or silicone dimethacrylate, depending on purposes. It may likewise comprise a silicon atom-containing or fluorine atom-containing surfactant for improving coating properties thereof. Further it may comprise a diazo resin for improving the adhesion between a light-sensitive layer and a primer layer. In addition, it may comprise a plasticizer (e.g., polyethylene glycol and tricresyl phosphate) and a stabilizer (e.g., phosphoric acid). The amount of these additives is generally not more than 10% by weight on the basis of the total weight of the composition for light-sensitive layer. Optionally, the composition may further comprise hydrophobic silica powder treated with a silane-coupling agent having (meth)acryloyl and/or allyl groups in an amount of not more than 50% by weight on the basis of the total weight of the composition for light-sensitive layer.

Moreover, examples of diazo resins used in the light-sensitive layer which comprises, for instance, a diazo resin and a binder resin are condensates of aromatic diazonium salts with formaldehyde. Particularly preferred include salts of condensates of p-diazodiphenylamine with formaldehyde or acetaldehyde such as inorganic salts of diazo resins which are reaction products of hexafluorophosphates, tetrafluoroborates, perchlorates or periodates with the foregoing condensates, and organic salts of diazo resins which are reaction products of the foregoing condensates with sulfonic acids as disclosed in U.S. Patent No. 3,200,309. The amount of the diazo resin present in the light-sensitive layer ranges from 20 to 95% by weight and preferably 35 to 80% by weight.

Various kinds of polymeric compounds can be used as the binder resins and preferred are copolymers of monomers having aromatic hydroxyl groups such as N-(4-hydroxyphenyl)acrylamide, N-(4-hydroxyphenyl)methacrylamide, o-, m- or p-hydroxystyrene or o-, m- or p-hydroxyphenyl methacrylate with other monomers as disclosed in J.P. KOKAI No. Sho 54-98613; polymers mainly comprising, as repeating units, those derived from hydroxyethyl (meth)acrylate as disclosed in U.S. Patent No. 4,123,276; copolymer resins comprising units derived from monomers having phenolic hydroxyl groups and monomers having alcoholic hydroxyl groups as disclosed in J.P. KOKAI No. Hei 3-158853; natural resins such as shellac and rosin; polyvinyl alcohol; polyamide resins as disclosed in U.S. Patent No. 3,751,257; linear polyurethane resins as disclosed in U.S. Patent No. 3,660,097; phthalate-modified polyvinyl alcohol resins; epoxy resins obtained through condensation of bisphenol A and epichlorohydrin; and celluloses such as cellulose acetate and cellulose butyrate.

In addition, the binder resins may be those mainly comprising light-sensitive polymers such as polyesters, polyamides and polycarbonates having light-sensitive groups: - CH=CH-CO- in the main chains or on the side chains. Examples thereof include light-sensitive polyesters obtained through condensation of phenylenediethyl acrylate, hydrogenated bisphenol A and triethylene glycol as disclosed in J.P. KOKAI No. Sho 55-40415; and light-sensitive polyesters derived from (2-propenylidene)malonate compounds such as cinnamylidene malonate and bifunctional glycols as disclosed in U.S. Patent No. 2,956,878.

The light-sensitive layers obtained using the foregoing diazo resins may likewise comprise additives such as dyes, surfactants, plasticizers and stabilizers.

The foregoing light-sensitive composition is dissolved in an appropriate solvent such as 2-methoxyethanol, 2-methoxyethyl acetate, propylene glycol methylethyl acetate, methyl lactate, ethyl lactate, propylene glycol monomethyl ether, ethanol, methyl ethyl ketone or N,N-dimethylacetamide or mixture thereof and then applied onto a substrate. The amount of the light-sensitive solution to be applied ranges from 0.1 to 20 $g/m^2$ and preferably 0.5 to 10 $g/m^2$ weighed after drying.

Ink-repellent Layer

The ink-repellent layer used in the present invention may be, for instance, a crosslinked silicone rubber layer or a crosslinked fluoroplastic.

The crosslinked silicone rubber layer used in the invention is a partially or completely crosslinked polydiorganosiloxane and has the following repeating units:

$-Si(R)_2-O-$

where in R represents an alkyl, aryl, alkenyl or a monovalent group comprising a combination of these groups, which may have functional groups selected from the group consisting of, for instance, halogen atoms, amino, hydroxyl, alkoxy, aryloxy, (meth)acryloxy and thiol groups. The silicone rubber layer may optionally comprise fine powder of inorganic substances such as silica, calcium carbonate and titanium oxide; auxiliary agents for adhesion such as silane-coupling agents, titanate-coupling agents and aluminum-coupling agents; and photopolymerization initiators.

A silicone rubber layer is formed by crosslinking and hardening a polysiloxane having a molecular weight ranging from several thousands to several hundreds of thousands and having a terminal functional group as a starting material for silicone rubber having the foregoing polysiloxane chain as a main skeleton, according to the following method. More specifically, a silane-coupling agent represented by the following general formula is mixed with the polysiloxane having hydroxyl groups on either or both ends thereof and optionally an organometal compound (such as an organotin compound, inorganic acid or amine) as a catalyst is added to the resulting mixture followed by heating the mixture comprising the polysiloxane and the silane-coupling agent or condensing the mixture at ordinary temperature to harden the same and to thus give a silicone rubber layer.

$R_n SiX_{4-n}$

wherein n is an integer of 1 to 3; R represents a substituent identical to that defined above in connection with the aforementioned substituent R; X represents a substituent such as -OH, $-OR^2$, -OAc, $-O-N=CR^2R^3$, -Cl, -Br or -I, wherein $R^2$ and $R^3$ are identical to R defined above and may be the same or different; and Ac represents an acetyl group.

Alternatively, a silicone rubber layer may likewise be formed by condensing and hardening an organopolysiloxane having terminal hydroxyl group(s), hydrogen polysiloxane cross-linking agent and, if necessary, the foregoing silane-coupling agent.

It is also effective to use an addition type silicone rubber layer obtained by crosslinking ≡SiH groups and -CH = CH-through an addition reaction. These addition type silicone rubber layers have advantages in that they are not greatly affected by humidity during hardening, that the crosslinking reaction thereof proceeds at a high speed and that silicone rubber layers having uniform physical properties can easily be obtained.

The addition type silicone rubber layer used herein is prepared through a reaction of a polyvalent hydrogen organopolysiloxane and a polysiloxane compound having at least two -CH = CH- bonds in the molecule and is desirably those obtained by crosslinking and hardening a composition comprising the following components (1) to (3):

(1) 100 parts by weight of an organopolysiloxane having at least two alkenyl groups (desirably vinyl groups) directly bonded to the silicon atoms per molecule;

(2) 0.1 to 1000 parts by weight of organohydrogenpolysiloxane having at least two SiH bonds per molecule; and

(3) 0.00001 to 10 parts by weight of a catalyst for addition reaction.

The alkenyl groups of Component (1) may be present at the termini or in the middle of the molecular chain and Component (1) may have organic substituents other than the alkenyl groups such as substituted or unsubstituted alkyl groups and/or aryl groups. Component (1) may comprise a small amount of hydroxyl groups. Component (2) forms a silicone rubber layer through the reaction with Component (1) and further ensures the adhesion between a silicone rubber layer and a photopolymerizable light-sensitive layer. The hydrogen groups may be present at the termini or in the middle of the molecular chain and Component (2) may have organic substituents other than the hydrogen groups which are selected from those listed above in connection with Component (1). It is generally preferred that 60% of the total number of the organic groups present in Components (1) and (2) are methyl groups in order to improve the ink-repellency of the resulting silicone rubber layer. The molecular structures of Components (1) and (2) may be linear, cyclic or branched ones and at least one of Components (1) and (2) has a molecular weight of more than 1, 000 from the viewpoint of physical properties of the resulting rubber. In this respect, the molecular weight of Component (1) is preferably more than 1,000.

Examples of these Components are $\alpha$ , $\omega$-divinylpolydimethylsiloxane and (methylvinylsiloxane)(dimethylsiloxane) copolymers having methyl groups on both ends for Component (1); polydimethylsiloxane having hydrogen groups on both ends, $\alpha$ , $\omega$-dimethylpolymethylhydrogensiloxane, (methylhydrogensiloxane)(dimethylsiloxane)copolymers having methyl groups on both ends and cyclic polymethylhydrogensiloxane for Component (2).

The addition catalysts as Component (3) may be arbitrarily selected from those known in the art, but preferably platinum compounds such as elemental platinum, platinum chloride, chloroplatinic acid and olefin-coordinated platinum. These compositions may further comprise crosslinking inhibitors such as vinyl group-containing organopolysiloxanes (e.g., tetracyclo(methylvinyl)siloxane), carbon-carbon triple bond-containing alcohols, acetone, methyl ethyl ketone, methanol, ethanol and propylene glycol monomethyl ether for controlling the hardening rate of these compositions.

These compositions undergo addition reactions immediately after mixing these three components to initiate hardening. In this respect, the hardening rate abruptly increases as the reaction temperature increases. For this reason, the hardening of the composition should be performed at a temperature range in which the substrate and the photopolymerizable light-sensitive layer do not cause any property change and which is maintained at a high level till the composition is completely hardened for extending the pot life of the composition till it is converted into rubber and for shortening the time required for hardening the composition on the light-sensitive layer. This is likewise preferable for ensuring the stable adhesion to the photopolymerizable light-sensitive layer. Moreover, it is preferred to separately prepare a solution comprising Components (1) and (3) and a coating solvent and a solution comprising Component (2) and a coating solvent and to mix these solutions immediately before the application thereof from the viewpoint of the pot life of the coating solution during the preparation thereof. In this respect, the crosslinking inhibitor is preferably added to the solution comprising Component (2).

The composition may comprise, in addition to the foregoing components, other additives such as known agents for imparting adhesion to the composition, e.g., alkenyl trialkoxysilanes and compounds represented by the following structural formulas:

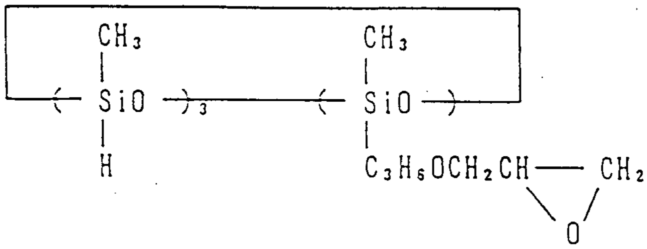

、

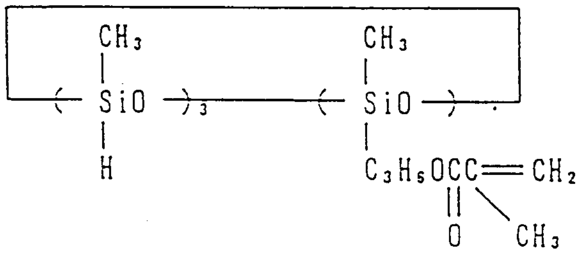

、

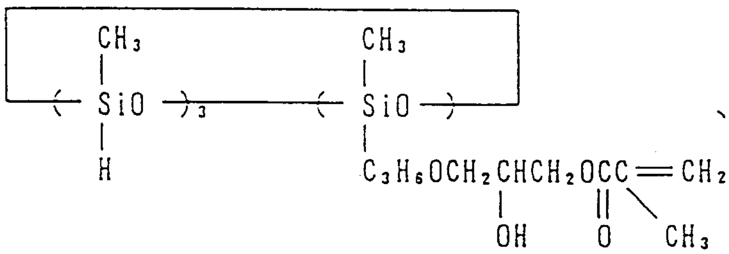

、

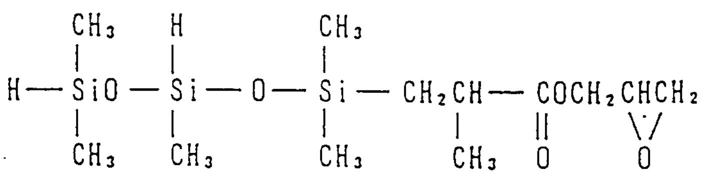

、

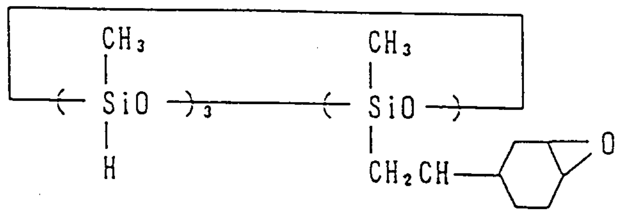

,

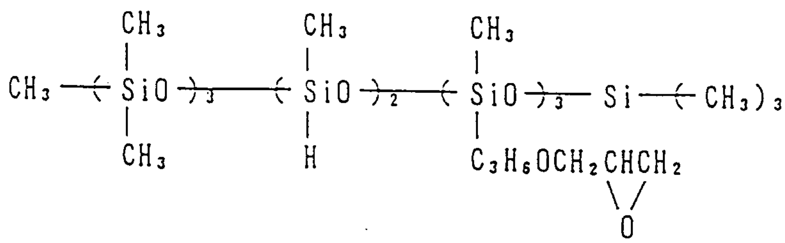

,

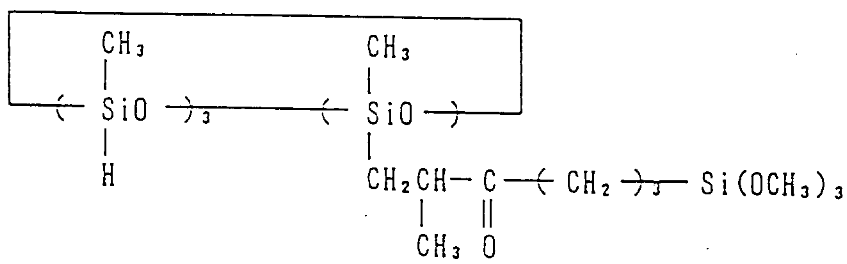

and compounds which are components of the condensed silicone rubber layer, for instance, hydroxyl group-containing organopolysiloxanes, terminal trimethylsilyl group-containing dimethylpolysiloxane, silicone oils comprising phenylmethylpolysiloxane copolymers and/or hydrolyzable functional group-containing silanes (or siloxanes). Known fillers such as silica may be added to the composition for the improvement of the strength of the resulting rubber layer.

The crosslinked fluoroplastics may, for instance, be those disclosed in J.P. KOKAI Nos. Sho 58-215411 and Hei 2-103047 and specific examples thereof are polymeric compounds which have, in the molecule, the following structural units: $CF_3$-, -$CF_2$-, =CF-, $CF_3$-O-, -$CF_2$-O- =CF-O- (the content of fluorine atoms being not less than 30% by weight and preferably not less than 50% by weight) and have, in the molecule, functional groups reactive with crosslinking agents or functional groups crosslinkable with one another such as epoxy, -OH, -COOH, -$NH_2$, -NCO and -NH- groups and which can be prepared by copolymerizing fluorine atom-containing (meth)acrylic monomers or fluorine atom-containing olefin monomers and (meth)-acrylic monomers or vinyl monomers, but the present invention is not restricted to these specific examples.

In regard to the ink-repellent layer used in the invention, if the layer is too thin, the ink repelllency thereof is reduced and the layer is easily damaged. On the other hand, if it is too thick, the developability of the resulting PS plate is impaired. Thus, the thickness of the ink-repellent layer preferably ranges from 0.5 to 5 $g/m^2$ and more preferably 1 to 3 $g/m^2$.

The dry PS plate explained above may further comprise a variety of ink-repellent layers on the foregoing ink-repellent layer. An adhesive layer may be applied between the light-sensitive layer and the ink-repellent layer for enhancing the adhesion therebetween or for preventing poisoning of the catalyst present in the composition for the ink-repellent layer.

Moreover, it is also possible to laminate the ink-repellent layer with a transparent film of a polymer such as polyethylene, polypropylene, polyvinyl chloride, polyvinylidene chloride, polyvinyl alcohol, polyethylene terephthalate or cellophane; or to apply a polymer coating to the ink-repellent layer for protecting the ink-repellent layer. These films may be oriented. Further these films may be matted or a polymer coating in which powder of, for instance, silica is dispersed may be applied to the films in order to improve the adhesion to a printing frame under vacuum during imagewise exposure thereof.

## Plate-Making

The dry PS plate of the present invention is imagewise exposed to light through an original transparency and then developed with a developer capable of partially or completely dissolving or swelling the light-sensitive layer on the image area (unexposed area).

The developers usable in the present invention may be those known as developers for dry PS plates, but preferably water or aqueous solutions of water-soluble organic solvents mainly comprising water. The concentration of the water-soluble solvent is desirably less than 40% by weight and in particular, the dry PS plate is preferably developed with pure water. Examples of known developers are aliphatic hydrocarbons (such as hexane, heptane, "Isopar E, H, G" (available from ESSO Chemical Company), or gasoline and kerosine), aromatic hydrocarbons (such as toluene and xylene) or halogenated hydrocarbons (such as trichloroethylene) to which the following polar solvents are added or the following polar solvents per se.

- Alcohols (such as methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, dipropylene glycol monomethyl ether, polyethylene glycol monomethyl ether, polypropylene glycol and tetraethylene glycol);
- Ketones (such as acetone and methyl ethyl ketone);
- Esters (such as ethyl acetate, methyl lactate, butyl lactate, propylene glycol monomethyl ether acetate, diethylene glycol acetate and diethyl phthalate); and
- Other polar solvents (such as triethyl phosphate and tricresyl phosphate).

Examples of developers usable in the invention further include the foregoing developers comprising organic solvents to which water is added, those obtained by solubilizing the foregoing organic solvents in water using, for instance, surfactants, these developers to which alkaline agents (such as sodium carbonate, diethanolamine and sodium hydroxide) are further added, or water (such as tap water, pure water and distilled water).

The developer may comprise a dye such as Crystal Violet, Victoria Pure Blue and Astrazone Red to simultaneously develop the PS plate and dye the image area thereof.

The development of the dry PS plate can be performed by any known method such as a method comprising rubbing the plate surface with a developing pad containing a developer or a method comprising pouring a developer on the plate surface and then rubbing the plate surface in water. The development may be performed at any temperature, but preferably the temperature ranges from 10 to 50 °C. Thus, the ink-repellent layer on the image area is removed and that portion serves as an ink-receiving portion.

The dry lithographic plate thus prepared can be designed in such a manner that the exposed image area is dyed with a dyeing solution to be able to detect the image area and to thus confirm the image-forming properties of the plate. When a developer does not comprise a dye for coloring the exposed image area, the plate is treated with a dyeing solution after the development. Only the exposed image area on the light-sensitive layer can be dyed by lightly rubbing the image area with a soft pad containing the dyeing solution and thus it can be confirmed that even highlight portions are sufficiently developed. The dyeing solution herein used comprises at least one member selected from the group consisting of disperse dyes, acid dyes and basic dyes dispersed or dissolved in water, alcohols, ketones, ethers or mixture thereof. It is effective to add, to the dyeing solution, other additives such as carboxylic acids, amines, surfactants and/or auxiliary agents for improving the dyeing ability of the solution.

Preferably, the lithographic printing plate dyed with the dyeing solution is then washed with water and dried. This allows the elimination of any stickiness of the plate surface and hence the improvement of handling properties of the printing plate.

When these lithographic printing plates are stored while putting them in layers, interleaves are, preferably, inserted between every neighbouring two plates to protect them.

It is preferred to perform the foregoing developing and dyeing treatments as well as the subsequent water-washing and drying processes in an automatic developing machine. Examples of such automatic developing machines preferably used are disclosed in U.S. Patent No. 5,055,870.

The dry PS plate comprising an aluminum plate as a substrate prepared by the method of the present invention permits the substantial improvement of coating properties of films applied onto the aluminum plate, developability and half-tone dot reproduction as well as storage stability of these properties.

The present invention will hereinafter be explained in more detail with reference to the following non-limitative working Examples and the effects practically achieved by the present invention will also be discussed in detail while comparing with Comparative Examples.

Examples 1 to 5 and Comparative Examples 1 to 4

Preparation of Substrate

Substrate 1

An aluminum plate (JIS A 1050) having a thickness of 0.3 mm which had been rolled by a known method was immersed in a 30% by weight aqueous solution of sulfuric acid maintained at 60 °C for 20 seconds to remove oils adhered to the surface thereof and then sufficiently washed with water to give an aluminum substrate 1.

Substrate 2

An aluminum plate (JIS A 1050) having a thickness of 0.3 mm which had been rolled by a known method was immersed in a 30% by weight aqueous solution of sulfuric acid maintained at 60 °C for 20 seconds to remove oils adhered to the surface thereof, then sufficiently washed with water, immersed in a 2.5% by weight aqueous solution of sodium silicate ($SiO_2/Na_2O$ molar ratio = 3.1 to 3.3) maintained at 70 °C for 10 seconds and washed with water to give an aluminum substrate 2.

Substrate 3

An aluminum plate (JIS A 1050) having a thickness of 0.3 mm which had been rolled by a known method was immersed in a 30% by weight aqueous solution of sulfuric acid maintained at 60 °C for 20 seconds to remove oils adhered to the surface thereof, then sufficiently washed with water, anodized at a current density of 1.5 A/$dm^2$ and 30 °C for 2 minutes in a 30% by weight aqueous solution of sulfuric acid, washing with water, immersed in a 2.5% by weight aqueous solution of sodium silicate ($SiO_2/Na_2O$ molar ratio = 3.1 to 3.3) maintained at 70 °C for 10 seconds and washed with water to give an aluminum substrate 3.

Comparative Substrate 4

An aluminum plate (JIS A 1050) having a thickness of 0.3 mm which had been rolled by a known method was immersed in a 10% by weight aqueous solution of NaOH maintained at 50 °C for 20 seconds to remove oils adhered to the surface thereof and then sufficiently washed with water to give an aluminum substrate 4.

Comparative Substrate 5

An aluminum plate (JIS A 1050) having a thickness of 0.3 mm which had been rolled by a known method was immersed in a 10% by weight aqueous solution of NaOH maintained at 50 °C for 20 seconds to remove oils adhered to the surface thereof, then immersed in a 30% by weight aqueous solution of sulfuric acid maintained at 60 °C for 20 seconds and sufficiently washed with water to give an aluminum substrate 5.

Comparative Substrate 6

An aluminum plate (JIS A 1050) having a thickness of 0.3 mm which had been rolled by a known method was immersed in a 3% by weight aqueous solution of sodium silicate ($SiO_2/Na_2O$ molar ratio = 3.1 to 3.3) maintained at 90 °C for 60 seconds and washed with water to give an aluminum substrate 6.

Primer Layer 1

A primer layer comprising the following components was applied onto the substrate prepared above in an amount of 4 g/$m^2$ (weighed after drying) and then dried and hardened through heating at 140 °C for 2

minutes.

| Component | Amount (part by weight) |
|---|---|
| Sanprene IB 1700D (a polyurethane resin available from Sanyo Chemical Industry Co., Ltd.) | 10 |
| Takenate D110N (an isocyanate crosslinking agent available from Takeda Chemical Industries, Ltd.) | 0.5 |
| KBM 603 (a silane-coupling agent available from Shin-Etsu Chemical Co., Ltd.) | 0.5 |
| $TiO_2$ | 0.1 |
| Defenser MCF 323 (a surfactant available from Dainippon 0.03 Ink and Chemicals, Inc.) | |
| propylene glycol methyl ether acetate | 50 |
| methyl lactate | 20 |

Primer Layer 2

A primer layer comprising the following components was applied onto the substrate prepared above in an amount of 4 $g/m^2$ (weighed after drying) and then dried and hardened through heating at 140 °C for 2 minutes. Then the layer was exposed to light for 100 counts using FT261V UDNS ULTRA-PLUS FLIPTOP PLATE MAKER vacuum exposure machine (available from Nu Arc Company) to thus completely photolytically decompose the diazonium salt.

| Component | Amount (part by weight) |
|---|---|
| Sanprene IB 1700D (a polyurethane resin available from Sanyo Chemical Industry Co., Ltd.) | 10 |
| $PF_6$ salt of condensate of p-diazodiphenylamine and formaldehyde | 0.3 |
| dodecylbenzenesulfonate of condensate of p-diazodiphenylamine and formaldehyde | 0.2 |
| $TiO_2$ | 0.1 |
| Defenser MCF 323 (a surfactant available from Dainippon 0.03 Ink and Chemicals, Inc.) | |
| propylene glycol methyl ether acetate | 50 |
| methyl lactate | 20 |
| $H_2O$ | 1 |

Light-Sensitive Layer

A photopolymerizable light-sensitive solution having the following composition was applied onto each aluminum plate, to which the primer layer had been applied, in an amount of 5 $g/m^2$ (weighed after drying) and dried at 100 °C for one minute.

| Component | Amount (part by weight) |
|---|---|
| Sanprene IB 1700D (available from Sanyo Chemical Industry Co., Ltd.) | 5.0 |
| A-600 (polyethylene glycol diacrylate available from Shin- 0.5 Nakamura Chemical Co., Ltd.) adduct of xylylenediamine (1 mole)/glycidyl methacrylate (4 moles) | 1.0 |
| ethyl Michler's ketone | 0.35 |
| 2-chlorothioxanthone | 0.10 |
| naphthalenesulfonate of Victoria Pure Blue BOH | 0.01 |
| Defenser MCF 323 (available from Dainippon Ink and Chemicals. Inc.) | 0.03 |
| methyl ethyl ketone | 10 |
| propylene glycol methyl ether | 25 |

Ink-Repellent Layer

A solution of a silicone rubber composition comprising the following components was applied onto each photopolymerizable light-sensitive layer thus formed so that the amount thereof was 2 g/m$^2$ (weighed after drying) and then dried at 140 °C for 2 minutes.

| Component | Amount (part by weight) |
|---|---|
| α, ω-divinylpolydimethylsiloxane (degree of polymerizatiom: about 700) | 9 |
| $(CH_3)_3$-Si-O-$(Si(CH_3)_2$-O$)_{30}$-$(SiH(CH_3)$-O$)_{10}$-$Si(CH_3)_3$ | 1.2 |
| polydimethylsiloxane (degree of polymerization: about 8,000) | 0.5 |
| olefin-chloroplatinic acid | 0.2 |
| crosslinking inhibitor | 0.3 |
| Isopar G (available from ESSO Chemical Company) | 140 |

Each silicone rubber layer thus formed was laminated with a one-side matted and biaxially oriented polypropylene film having a thickness of 12 µm so that the non-matted side of the latter came in contact with the silicone rubber layer to give a dry PS plate.

Plate-Making Treatment

After the PS plates obtained above were stored at room temperature for 3 months, a positive film carrying half-tone dot images at a density of 200 lines/inch and a gray scale (G/S) having an optical density difference of 0.15 were put on each PS plate and each assembly was exposed to light for 30 counts using FT261V UDNS ULTRA-PLUS FLIPTOP PLATE MAKER vacuum exposure machine (available from Nu Arc Company) and then the laminate film was peeled off.

Each imagewise exposed PS plate was immersed in a 20% aqueous solution of diethylene glycol monoethyl ether maintained at 40 °C for one minute and rubbed with a developing pad in water to remove the silicone rubber layer on the unexposed area.

Subsequently, the developed PS plates were dyed with a dyeing solution having the following composition for the evaluation of the developability of the plate. Moreover, there was evaluated the half-tone dot reproduction (H.T.D.R.) observed at the gray scale sensitivity of 9 step at which the 9th step of the gray scale becomes solid and at the solid portion (half-tone dot area of the reproducible highlight portion; unit: %). The results thus obtained are listed in the following Table 1.

Dyeing Solution

| Component | Amount (part by weight) |
|---|---|
| Crystal Violet<br>diethylene glycol monoethyl ether<br>pure water | 0.1<br>15<br>85 |

Table 1: Results of Evaluation

| Ex. No. | Subst-rate | Primer Layer | Developability | H.T.D.R. (%) |
|---|---|---|---|---|
| 1 | 1 | 1 | good | 1 |
| 2 | 2 | 1 | good | 1 |
| 3 | 2 | 2 | good | 1 |
| 4 | 3 | 1 | good | 1 |
| 5 | 3 | 2 | good | 1 |
| Comp. Ex. | | | | |
| 1 | 4 | 1 | silicone layer on the unexposed area could not be removed | -- |
| 2 | 5 | 1 | silicone layer on the unexposed area could not sufficiently be removed | 5 |
| 3 | 5 | 2 | silicone layer on the unexposed area could not sufficiently be removed | 5 |
| 4 | 6 | 2 | silicone layer on the unexposed area could not sufficiently be removed | 5 |

**Claims**

**1.** A method for preparing a presensitized plate for use in making a lithographic printing plate requiring no dampening water which comprises an aluminum plate as a substrate, wherein the method comprises the steps of degreasing at least one side of the aluminum substrate to which a light-sensitive layer is applied with an aqueous solution of an acid and then applying a light-sensitive layer and an ink-repellent layer to the degreased substrate.

2. The presensitized plate of claim 1 wherein the acid is sulfuric acid or phosphoric acid.

3. The presensitized plate of claim 1 wherein the degreasing is carried out at an acid concentration ranging from 20 to 50% by weight, a temperature ranging from 40 to 80 °C for 1 to 100 seconds.

4. The presensitized plate of claim 1 wherein the aluminum plate is subjected to a surface-treatment selected from graining, anodization and/or treatments with aqueous solutions of silicates after the degreasing treatment.

5. The method of claim 4 wherein the aluminum substrate is treated with an aqueous solution of a silicate after the degreasing treatment and before the application of the light-sensitive layer.

6. The presensitized plate of claim 1 wherein the aluminum plate is treated with a silane-coupling agent after the degreasing treatment.

7. The method of claim 1 wherein a primer layer is applied onto the aluminum substrate after the degreasing treatment and before the application of the light-sensitive layer.

8. The method of claim 1 wherein the light-sensitive layer is a photopolymerizable light-sensitive layer which comprises at least (1) a monomer, oligomer or macromonomer having at least one photopolymerizable ethylenically unsaturated group; (2) a polymeric compound having a film-forming ability; and (3) a photopolymerization initiator.

9. The method of claim 1 wherein the ink-repellent layer is a partially or completely crosslinked polydiorganosiloxane which has the following repeating units:

$-Si(R)_2-O-$

where in R represents an alkyl, aryl, alkenyl or a monovalent group comprising a combination of these groups which may have functional groups selected from the group consisting of halogen atoms, amino, hydroxyl, alkoxy, aryloxy, (meth)acryloxy and thiol groups.

10. The method of claim 1 wherein the ink-repellent layer is an addition type silicone rubber layer obtained by crosslinking and hardening a composition comprising the following components:
(1) 100 parts by weight of an organopolysiloxane having at least two alkenyl groups directly bonded to the silicon atoms per molecule;
(2) 0.1 to 1000 parts by weight of organohydrogenpolysiloxane having at least two SiH bonds per molecule; and
(3) 0.00001 to 10 parts by weight of a catalyst for addition reaction.

European Patent Office

# EUROPEAN SEARCH REPORT

Application Number

EP 93 10 3896

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,D | US-A-5 061 598 (Y.ABE ET AL.)<br>* column 2, line 26 - line 55 *<br>* column 6, line 1 - line 25 *<br>--- | 1 | B41N3/03<br>B41M1/08<br>G03F7/075 |
| A | US-A-4 970 014 (S.M.GARCIA)<br>* column 3, line 60 - column 4, line 4; claim 1 *<br>--- | 1-10 | |
| A | GB-A-2 160 222 (FUJI PHOTO FILM COMPANY LIMITED)<br>* page 2, line 9 - line 21 *<br>----- | 1-10 | |
| | | | TECHNICAL FIELDS SEARCHED (Int. Cl.5) |
| | | | B41N<br>B41M<br>G03F<br>C23G |

The present search report has been drawn up for all claims

| Place of search | Date of completion of the search | Examiner |
|---|---|---|
| THE HAGUE | 27 MAY 1993 | BACON A.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)